# FASCICULE DE BREVET EUROPEEN

(11) **EP 1 495 494 B1**
(45) Date de publication et mention de la délivrance du brevet: **25.06.2008**
(21) Numéro de dépôt: 03746331.2
(22) Date de dépôt: 10.04.2003
(51) Int. Cl.: H01L 27/146, H01L 31/02

(54) **MATRICE DE PHOTODETECTEURS, A PIXELS ISOLES PAR DES MURS, HYBRIDEE SUR UN CIRCUIT DE LECTURE**
PHOTODETEKTORMATRIX MIT DURCH WÄNDE ISOLIERTEN PIXELN, HYBRIDISIERT AUF EINE LESESCHALTUNG
PHOTODETECTOR MATRIX WITH PIXELS ISOLATED BY WALLS, HYBRIDISED ONTO A READING CIRCUIT

(30) Priorité: 12.04.2002 FR 0204617
(43) Date de publication de la demande: 12.01.2005
(73) Titulaire: COMMISSARIAT A L'ENERGIE ATOMIQUE, 75015 Paris (FR)
(72) Inventeur: GIDON, Pierre, F-38130 Echirolles (FR); PANTIGNY, Philippe, F-38640 Claix (FR)
(74) Mandataire: Poulin, Gérard
(86) Numéro de dépôt international: PCT/FR2003/001139
(87) Numéro de publication internationale: WO 2003/088359

(56) Documents cités:
- US-A- 5 075 238
- US-A- 5 602 414
- US-A- 5 729 020
- PATENT ABSTRACTS OF JAPAN vol. 013, no. 110 (E-728), 16 mars 1989 (1989-03-16) -& JP 63 281460 A (FUJITSU LTD), 17 novembre 1988 (1988-11-17)
- PATENT ABSTRACTS OF JAPAN vol. 2002, no. 02, 2 avril 2002 (2002-04-02) -& JP 2001 291892 A (HAMAMATSU PHOTONICS KK), 19 octobre 2001 (2001-10-19)

## Description

### DOMAINE TECHNIQUE

L'invention concerne une matrice de photodétecteurs, à pixels isolés par des murs, hybridée sur un circuit de lecture.

Les matrices de détecteurs ont le plus souvent pour but de retranscrire des images. Elles peuvent aussi être utilisées pour capter des signaux lumineux issus d'appareils de mesure. Le spectre lumineux qu'elles traitent peut aller de l'infrarouge à l'ultra-violet. Elles délivrent des signaux électriques en rapport avec les intensités lumineuses reçues. Certaines délivrent plusieurs signaux en parallèle, soit pour transmettre l'information plus rapidement, soit pour séparer les signaux issus de filtres de couleurs (donc de longueurs d'onde) différents.

### ETAT DE LA TECHNIQUE ANTERIEURE

Il existe de multiples structures de matrices de photodétecteurs.

On connaît des structures de photodétecteurs hybrides comprenant une matrice de photodiodes à électrode commune réalisées simultanément dans une plaque de matériau semiconducteur. Cette plaque est hybridée sur un circuit amplificateur et amincie si nécessaire:

Les différentes photodiodes réalisées dans la plaque de matériau semiconducteur ne sont pas séparées les unes des autres électriquement ou optiquement. Seules la résistivité du matériau semiconducteur et la distance aux contacts électriques font que le photocourant engendré est collecté par un plot de connexion ou par un autre. le document US5,729,020 décrit un capteur du type hybride. Le document US 5,075,238 décrit un capteur avec des murs pour séparer les pixels.

### EXPOSÉ DE L'INVENTION

Il est proposé selon la présente invention d'optimiser les performances de détection des matrices de photodétecteurs grâce à la présence de murs séparant les différents photodétecteurs d'une matrice de photodétecteurs.

L'invention a donc pour objet une matrice de photodétecteurs destinée à être hybridée sur un circuit de lecture et constituée à partir d'une plaque de matériau semiconducteur présentant une face de réception d'une lumière à détecter et une face opposée dite face d'hybridation, la plaque étant divisée en pixels, chaque pixel constituant un photodétecteur, la face d'hybridation présentant des plots de connexion permettant d'hybrider la matrice de photodétecteurs au circuit de lecture, caractérisée en ce que les pixels sont séparés les uns des autres par des murs formés transversalement dans toute l'épaisseur de la plaque.

Les murs formés transversalement dans la plaque peuvent être perpendiculaires à la plaque et former un réseau à mail-les rectangulaires ou carrées. Ils peuvent aussi être inclinés par rapport à la plaque. Ils peuvent former un réseau à mailles en forme de prisme, de cône, etc....

Selon un premier mode de réalisation préféré, chaque photodétecteur comprend une zone dopée selon un premier type de dopage et en contact électrique avec un plot de connexion correspondant de la face d'hybridation, chaque photodétecteur comprenant également une zone dopée selon un deuxième type de dopage complémentaire du premier type de dopage et en contact électrique avec une électrode commune à tous les photodétecteurs et supportée par la face d'hybridation, les murs présentant une paroi électriquement isolante aux photodétecteurs.

Chaque photodétecteur peut aussi comprendre une zone dopée selon un premier type de dopage et en contact électrique avec un plot de connexion correspondant de la face d'hybridation, chaque photodétecteur comprenant également une zone dopée selon un deuxième type de dopage complémentaire du premier type de dopage et en contact électrique avec un plot de connexion correspondant de la face d'hybridation, les murs présentant une paroi électriquement isolante aux photodétecteurs.

Selon un deuxième mode de réalisation préféré, chaque photodétecteur comprend une zone dopée selon un premier type de dopage et en contact électrique avec un plot de connexion correspondant de la face d'hybridation, chaque photodétecteur comprenant également une zone dopée selon un deuxième type de dopage complémentaire du premier type de dopage et en contact électrique avec des moyens conducteurs électriques des murs, les moyens conducteurs électriques des murs étant connectés à une électrode commune.

L'électrode commune peut être supportée par la face d'hybridation de la matrice de photodétecteurs.

La zone dopée selon le deuxième type de dopage peut s'étendre sur toute l'épaisseur de la plaque de matériau semiconducteur. Chaque photodétecteur peut comprendre en outre une couche de la plaque de matériau semiconducteur, adjacente à la face de réception d'une lumière, dopée selon le deuxième type de dopage.

Selon une variante de réalisation, les murs présentant un sommet n'atteignant pas la face de réception d'une lumière, la zone dopée selon le deuxième type de dopage est située entre ledit sommet et la face de réception d'une lumière.

Selon une autre variante de réalisation, la zone dopée selon le deuxième type de dopage est localisée près de la face de réception d'une lumière.

Selon encore une autre variante de réalisation, ladite électrode commune est supportée par la face de réception d'une lumière, des moyens de liaison électrique traversant la plaque de matériau semiconducteur pour relier ladite électrode commune à une plage conductrice située sur la face d'hybridation. De préférence, l'électrode commune comprend des conducteurs électriques possédant une forme permettant de réfléchir la lumière à détecter vers les parties de la face de réception dépourvues de conducteurs électriques. Cette forme des conducteurs électriques peut être une pointe dirigée vers la lumière à détecter.

Selon un troisième mode de réalisation préféré, chaque photodétecteur comprend une zone dopée selon un premier type de dopage et une zone dopée selon un deuxième type de dopage complémentaire du premier type de dopage, ces zones dopées étant localisées près de la face de réception d'une lumière et étant reliées à des plots de connexion correspondant de la face d'hybridation par des moyens conducteurs électriques prévus dans les murs. Les zones dopées selon le premier type de dopage peuvent correspondre à des murs présentant un sommet n'atteignant pas la face de réception d'une lumière, les zones dopées selon le premier type de dopage étant alors localisées entre les sommets des murs et la face de réception d'une lumière, les zones dopées selon le deuxième type de dopage correspondant à des murs présentant un sommet atteignant la face de réception d'une lumière. Les zones dopées peuvent correspondre à des murs présentant un sommet n'atteignant pas la face de réception d'une lumière, les zones dopées étant alors localisées entre les sommets des murs et la face de réception d'une lumière. Les zones dopées peuvent aussi correspondre à des murs présentant un sommet atteignant la face de réception d'une lumière.

Eventuellement, la face de réception d'une lumière supporte au moins un élément optique. L'élément optique peut être un élément choisi parmi une couche antireflet, un filtre coloré et un système de concentration de lumière.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est une vue en coupe transversale d'une matrice de photodétecteurs hybridée sur un circuit de lecture, selon un premier mode de réalisation de l'invention,
- la figure 2 est une vue en coupe transversale d'une matrice de photodétecteurs hybridée sur un circuit de lecture, selon un deuxième mode de réalisation de l'invention,
- la figure 3 est une vue en coupe transversale d'une matrice de photodétecteurs hybridée sur un circuit de lecture, selon une première variante d'un troisième mode de réalisation de l'invention,
- la figure 4 est une vue en coupe transversale d'une matrice de photodétecteurs hybridée sur un circuit de lecture, selon une deuxième variante du troisième mode de réalisation de l'invention,
- la figure 5 est une vue en coupe transversale d'une matrice de photodétecteurs hybridée sur un circuit de lecture, selon un quatrième mode de réalisation de l'invention,
- la figure 6 est une vue en coupe transversale d'une matrice de photodétecteurs hybridée sur un circuit de lecture, selon un cinquième mode de réalisation de l'invention,
- les figures 7 et 8 sont des vues en coupe transversale d'une matrice de photodétecteurs hybridée sur un circuit de lecture, selon le quatrième mode de réalisation de l'invention, complétée d'un élément optique,
- les figures 9A à 9J illustrent la réalisation d'une matrice de photodétecteurs hybridée sur un circuit de lecture selon le premier mode de réalisation de l'invention,
- les figures 10A à 10D illustrent la réalisation d'une matrice de photodétecteurs hybridée sur un circuit de lecture selon le deuxième mode de réalisation de l'invention,
- les figures 11A à 11H illustrent la réalisation d'une matrice de photodétecteurs hybridée sur un circuit de lecture selon les variantes du troisième mode de réalisation de l'invention,
- les figures 12A et 12B illustrent la réalisation d'une matrice de photodétecteurs hybridée sur un circuit de lecture selon le quatrième mode de réalisation de l'invention,
- les figures 13A à 13F illustrent la réalisation d'une matrice de photodétecteurs hybridée sur un circuit de lecture selon le cinquième mode de réalisation de l'invention.

### DESCRIPTION DETAILLEE DE MODES DE REALISATION DE L'INVENTION

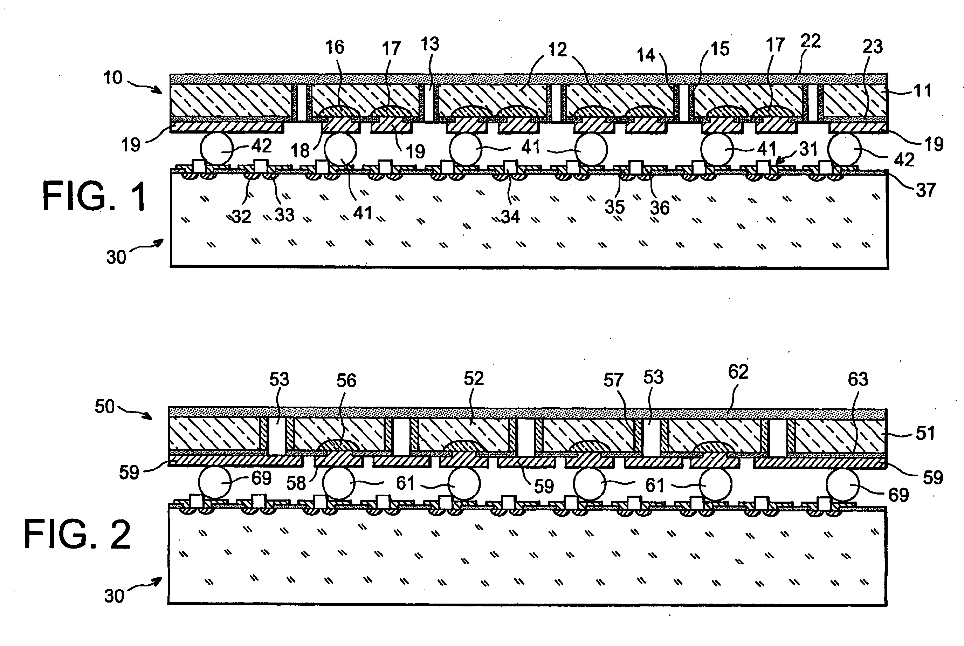

La figure 1 est une vue en coupe transversale d'une matrice de photodétecteurs hybridée sur un circuit de lecture, selon un premier mode de réalisation de l'invention. La matrice de photodétecteurs est une matrice avec les deux noeuds électriques du dipôle photodétecteur sur la face circuit.

La matrice de photodétecteurs 10 est constituée à partir d'une plaque de matériau semiconducteur 11 divisée en pixels ou photodétecteurs 12 par des murs disposés transversalement par rapport à la plaque 11 et selon toute son épaisseur. Les murs forment ainsi un quadrillage. Ils peuvent être constitués d'un ou de plusieurs matériaux, au moins le matériau des murs en contact avec le matériau semiconducteur des photodétecteurs est isolant électrique. Dans le cas représenté à la figure 1, les murs comprennent une paroi 13 prise en sandwich entre deux parois électriquement isolantes 14 et 15.

Chaque pixel 12 comporte deux zones dopées complémentaires pour réaliser la prise de contact entre le métal et le semiconducteur et la collecte des charges. La zone dopée 16 assure la prise de contact avec le plot de connexion 18 du photodétecteur. La zone dopée 17 assure la prise de contact avec l'électrode 19 qui est une électrode commune pour tous les photodétecteurs.

La matrice de photodétecteurs 10 est recouverte, sur la face destinée à recevoir une lumière à détecter, d'une couche électriquement isolante et transparente 22. Elle est recouverte, sur sa face d'hybridation, d'une couche électriquement isolante 23 ouverte localement pour assurer les différentes liaisons électriques.

La figure 1 montre également un circuit de lecture 30 associé à la matrice de photodétecteurs 10. Le circuit de lecture 30 est réalisé sur un substrat en silicium. De manière connue, des amplificateurs et circuits de traitement CMOS 31 (ou bipolaires ou BiCMOS) ont été réalisés sur le substrat. A titre d'exemple, on reconnaît des zones de dopage P ou N 32 et 33, les grilles en polysilicium 34, des contacts de drain et de source 35 et 36 et une couche d'oxyde de silicium gravée 37.

L'hybridation de la matrice de photodétecteurs 10 sur le circuit de lecture 30 se fait au moyen de billes fusibles. Les plots de connexion 18 des photodétecteurs sont reliés au circuit de lecture par des billes 41. L'électrode commune 19 est reliée au circuit de lecture par des billes 42.

Un des avantages de ce mode de réalisation est que le signal électrique généré en face de chaque paire de contacts électriques 18, 19 est obligatoirement capté par ces contacts et ne peut dériver vers les contacts des photodétecteurs voisins. Les images sont alors mieux résolues et les taches d'éblouissement, par les sources ponctuelles intenses, réduites. L'électrode 19 est reliée électriquement au circuit de lecture 30 par les bords. On peut envisager de supprimer l'électrode commune et de rajouter une bille par noeud électrique, pour des applications particulières d'amplification différentielle.

La figure 2 est une vue en coupe transversale d'une matrice de photodétecteurs hybridée sur un circuit de lecture, selon un deuxième mode de réalisation de l'invention. La matrice de photodétecteurs est une matrice à contacts de base communs pris par les murs conducteurs.

La matrice de photodétecteurs 50 est constituée à partir d'une plaque de matériau semiconducteur 51 divisée en photodétecteurs 52 par des murs quadrillant la plaque 51 comme pour la figure 1. Les murs sont constitués d'une paroi conductrice 53.

Chaque photodétecteur 52 comporte deux zones dopées complémentaires pour réaliser la prise de contact entre le métal et le semiconducteur et la collecte des charges. La zone dopée 56, au centre du photodétecteur 52, assure la prise de contact électrique avec le plot de connexion 58 du photodétecteur. La zone dopée périphérique 57 assure la prise de contact électrique avec la paroi conductrice 53 du mur. Les parois conductrices 53 sont toutes connectées à une électrode commune 59.

La matrice de photodétecteurs 50 est recouverte, sur la face destinée à recevoir une lumière à détecter, d'une couche électriquement isolante et transparente 62. Elle est recouverte sur sa face d'hybridation d'une couche électriquement isolante 63 ouverte localement pour assurer les différentes liaisons électriques.

La figure 2 montre également un circuit de lecture 30 associé à la matrice de photodétecteurs 50. Il est similaire à celui de la figure 1.

L'hybridation de la matrice de photodétecteurs 50 sur le circuit de lecture 30 se fait au moyen de billes fusibles. Les plots de connexion 58 des photodétecteurs sont reliés au circuit de lecture par des billes 61. L'électrode commune 59 est reliée au circuit de lecture par des billes 69.

Cette réalisation a pour avantage de ne présenter qu'un seul plot de connexion par photodétecteur, ce qui permet de réduire l'encombrement. Selon la nature du rayonnement détecté, il peut être préférable d'avoir une couche dopée sur la face de réception d'une lumière à détecter. Le dopant est alors du même type que le dopant de la zone semiconductrice en contact avec le mur conducteur.

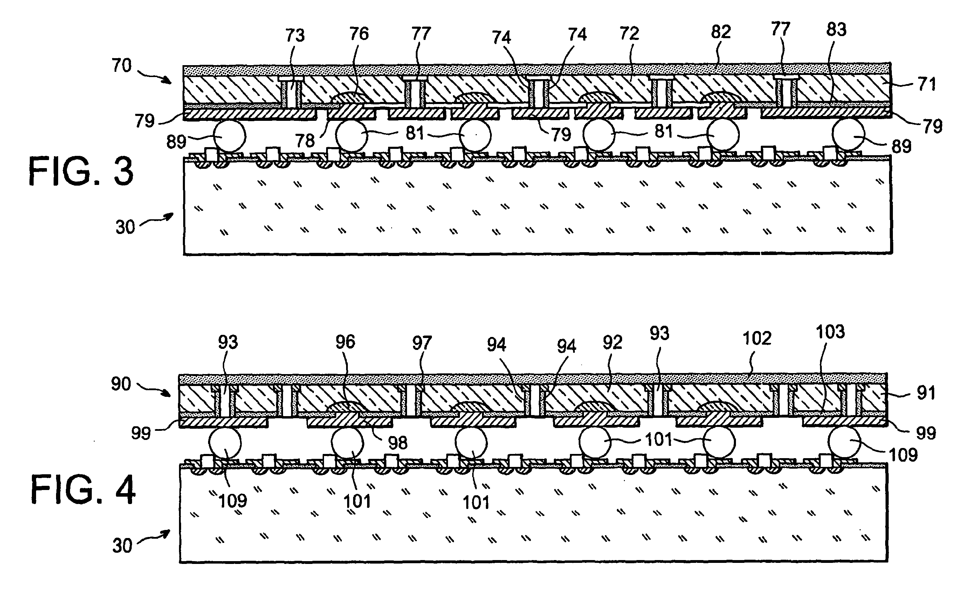

La figure 3 est une vue en coupe transversale d'une matrice de photodétecteurs hybridée sur un circuit de lecture selon une première variante d'un troisième mode de réalisation de l'invention. La matrice de photodétecteurs est une matrice à contacts de base communs pris sur la face éclairée en bout de mur conducteur.

La matrice de photodétecteurs 70 est constituée à partir d'une plaque de matériau semiconducteur 71 divisée en photodétecteurs 72 par des murs quadrillant la plaque 71 comme pour la figure 1. Les murs sont constitués d'une paroi conductrice 73 prise en sandwich entre deux fines couches électriquement isolantes 74.

Les murs débouchent sur la face d'hybridation de la plaque 71 où les parois conductrices 73 viennent en contact électrique avec une électrode commune 79 qui s'étend également sur les bords de la plaque 71. Le sommet des murs laisse subsister des zones de matériau semiconducteur avant la face de réception de la lumière de la plaque 71.

La partie 77 de matériau semiconducteur comprise entre la face de réception de la lumière de la plaque 71 et le sommet d'un mur est dopée.

Chaque photodétecteur 72 possède en son centre une zone dopée 76 de manière complémentaire par rapport au dopage des parties 77 et située côté face d'hybridation de la matrice de photodétecteurs. Les zones dopées 76 sont en contact électrique avec les plots de connexion correspondants 78.

La matrice de photodétecteurs 70 est recouverte, sur sa face destinée à recevoir une lumière à détecter, d'une couche électriquement isolante et transparente 82. Elle est recouverte, sur sa face d'hybridation, d'une couche électriquement isolante 83 ouverte localement pour assurer les différentes liaisons électriques.

La figure 3 montre également un circuit de lecture 30 associé à la matrice de photodétecteurs 70. Il est similaire à celui de la figure 1.

L'hybridation de la matrice de photodétecteurs 70 sur le circuit de lecture 30 se fait au moyen de billes fusibles. Les plots de connexion 78 des photodétecteurs sont reliés au circuit de lecture par des billes 81. L'électrode commune 79 est reliée au circuit de lecture par des billes 89.

La figure 4 est une vue en coupe transversale d'une matrice de photodétecteurs hybridée sur un circuit de lecture selon une deuxième variante d'un troisième mode de réalisation de l'invention. La matrice de photodétecteurs est aussi une matrice à contacts de base communs pris sur la face éclairée en bout de mur conducteur.

La matrice de photodétecteurs 90 est constituée à partir d'une plaque de matériau semiconducteur 91 divisée en photodétecteurs 92 par des murs quadrillant la plaque 91 comme pour la figure 1. Les murs sont constitués d'une paroi conductrice 93 prise en sandwich entre deux fines couches électriquement isolantes 94.

Les murs débouchent sur la face d'hybridation de la plaque 91. Les parois conductrices des murs des bords de plaque viennent en contact électrique avec une électrode 99 commune à tous les murs. Les murs débouchent aussi sur la face de réception d'une lumière de la plaque 91.

Chaque photodétecteur 92 comporte deux zones dopées complémentaires pour réaliser la prise de contact entre le métal et le semiconducteur et la collecte des charges. La zone dopée 96, au centre du photodétecteur 92, assure la prise de contact électrique avec le plot de connexion 98 du photodétecteur. La zone dopée périphérique 97, située côté face de réception d'une lumière, assure la prise de contact électrique avec la paroi conductrice 93 du mur, cette paroi n'étant pas recouverte des fines couches isolantes à ce niveau

La matrice de photodétecteurs est recouverte, sur sa face destinée à recevoir une lumière à détecter, d'une couche électriquement isolante et transparente 102. Elle est recouverte, sur sa face d'hybridation, d'une couche électriquement isolante 103 ouverte localement pour assurer les différentes liaisons électriques.

La figure 4 montre également un circuit de lecture 30 associé à la matrice de photodétecteurs 90. Il est similaire à celui de la figure 1.

L'hybridation de la matrice de photodétecteurs 90 sur le circuit de lecture 30 se fait au moyen de billes fusibles. Les plots de connexion 98 des photodétecteurs sont reliés au circuit de lecture par des billes 101. L'électrode commune 99 est reliée au circuit de lecture par des billes 109.

Les structures représentées aux figures 3 et 4 permettent de réduire le volume de matériau semiconducteur dopé. Cette condition est souvent nécessaire car les zones dopées recombinent les charges créées par la lumière en leur sein. La multiplication des contacts est nécessaire pour réduire la résistance de collecte du courant. Ces deux structures permettent un ajustement aux valeurs du compromis imposé par les matériaux détecteurs (semiconducteurs) et les longueurs d'onde à détecter.

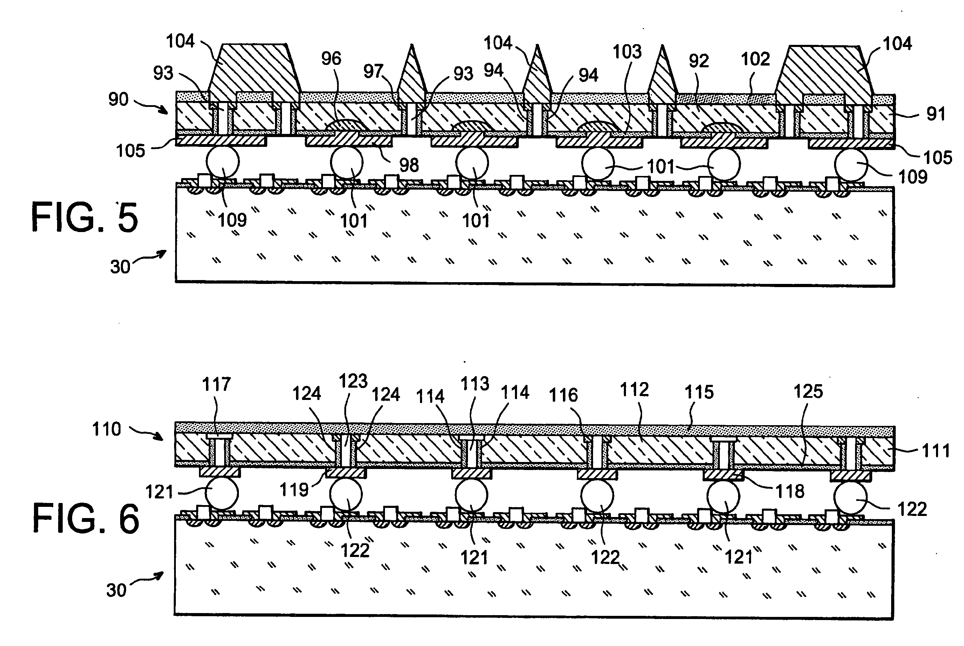

La figure 5 est une vue en coupe transversale d'une matrice de photodétecteurs hybridée sur un circuit de lecture selon un quatrième mode de réalisation de l'invention. La matrice de photodétecteurs est une matrice à contacts communs repris par piste métallique en face éclairée formant un micro-concentrateur optique.

La structure représentée à la figure 5 reprend beaucoup d'éléments décrits sur la figure 4. Ces éléments sont référencés à l'identique. Elle aurait pu, de même, reprendre les éléments des figures 2 ou 3 à titre de variantes.

A la différence de la figure 4, la matrice de photodétecteurs de la figure 5 possède, sur la face de réception d'une lumière à détecter, des conducteurs électriques 104 formant une électrode commune connectée aux zones dopées 97. La couche électriquement isolante et transparente 102 est ouverte localement pour assurer cette connexion. L'électrode commune 104 est reliée électriquement à des plages conductrices 105, disposées en bordure de plaque et sur la face d'hybridation, par exemple grâce à des parois conductrices 93 de murs situés également en bordure de plaque. Les plages conductrices 109 sont reliées au circuit de lecture 30 par les billes 109. Si les parois 93 sont électriquement isolantes, alors l'électrode commune 104 peut être reliée au circuit 30 par un fil de liaison en bord de circuit.

La matrice de photodétecteurs de la figure 5 présente une électrode commune 104 qui est connue pour être électriquement avantageuse. Cependant, il est avantageux de donner aux conducteurs de l'électrode commune 104 une forme en pointe comme indiqué sur la figure. Les faces des conducteurs permettent de réfléchir la lumière incidente vers le matériau semiconducteur, minimisant ainsi les pertes optiques. Un autre avantage est d'autoriser les points de connexion électrique en bordure de plaque sur la face éclairée. Cette disposition simplifie la mise en place finale du composant dans un dispositif.

La figure 6 est une vue en coupe transversale d'une matrice de photodétecteurs hybridée sur un circuit de lecture selon un cinquième mode de réalisation de l'invention. La matrice de photodétecteurs est une matrice à contacts par les murs avec les bases et émetteurs reportés en face éclairée.

La lumière, pour certaines longueurs d'onde, génère des charges électriques dès les premières couches de matériau semiconducteur rencontrées. Il est alors préférable d'avoir toutes les zones dopées du matériau semiconducteur proches de la surface éclairée pour collecter au plus vite les charges. La structure représentée à la figure 6 permet d'y parvenir. Pour cela, un triple jeu de murs est réalisé successivement dans la plaque de matériau semiconducteur. Le premier jeu contient l'un des dopants, le deuxième jeu contient l'autre dopant et le troisième jeu est électriquement isolant. Le troisième jeu n'est pas représenté sur la figure 6 car il est perpendiculaire aux murs représentés sur cette coupe.

La matrice de photodétecteurs 110 est constituée à partir d'une plaque de matériau semiconducteur 111 divisée en photodétecteurs 112 par des murs quadrillant la plaque 111.

La figure 6 montre deux jeux de murs disposés en alternance. Un premier jeu de murs visible sur cette figure est constitué, comme pour la figure 3, d'une paroi électriquement conductrice 113 prise en sandwich entre deux fines couches électriquement isolantes 114 et venant en contact électrique avec une zone superficielle 117 de matériau semiconducteur dopée selon un premier type de dopage. La zone dopée 117 est située côté face de réception d'une lumière à détecter. Un deuxième jeu de murs visible sur cette figure est constitué, comme pour la figure 4, d'une paroi électriquement conductrice 123 prise en sandwich entre deux fines couches électriquement isolantes 124 à l'exception de son extrémité proche de la face de réception d'une lumière à détecter. A ce niveau, la paroi conductrice 123 est en contact électrique avec une zone localisée 116 de matériau semiconducteur dopée selon un deuxième type de dopage complémentaire du premier type de dopage.

Les parois conductrices 113 sont connectées, côté face d'hybridation, à des plots 118. Les parois conductrices 123 sont connectées, côté face d'hybridation, à des plots 119.

La matrice de photodétecteurs 140 est recouverte, sur sa face destinée à recevoir une lumière à détecter, d'une couche électriquement isolante et transparente 115. Elle est recouverte, sur sa face d'hybridation, d'une couche électriquement isolante 125 ouverte localement pour assurer les différentes liaisons électriques.

La figure 6 montre également un circuit de lecture 30 associé à la matrice de photodétecteurs 110. Il est similaire à celui de la figure 1.

L'hybridation de la matrice de photodétecteurs 110 sur le circuit de lecture 30 se fait au moyen de billes fusibles. Les plots de connexion 118 des photodétecteurs sont reliés au circuit de lecture par des billes 121. Les plots de connexion 119 des photodétecteurs sont reliés au circuit de lecture par des billes 122.

Les plots de connexion étant sur les limites des pixels, ils sont donc communs à deux pixels. Le nombre de contacts nécessaires pour lire les informations par le circuit CMOS est plus grand que pour les structures précédentes car aucun contact n'est relié à un pixel unique.

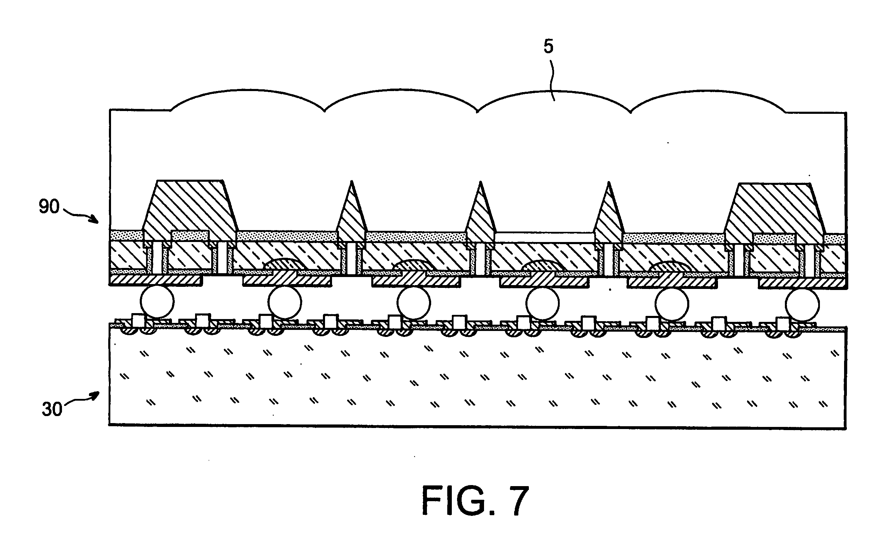

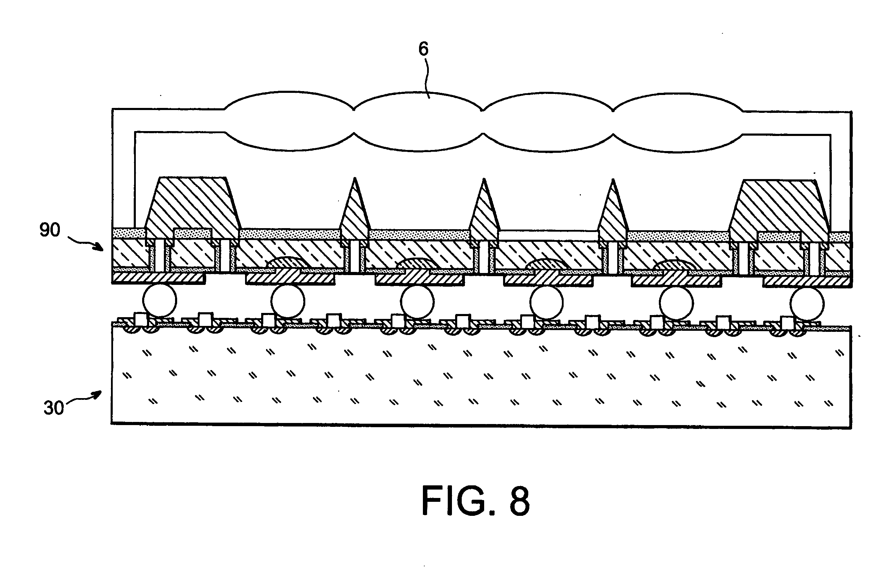

Les figures 7 et 8 sont des vues en coupe transversale d'une matrice de photodétecteurs hybridée sur un circuit de lecture, complétée d'un élément optique.

Les matrices de photodétecteurs représentées sur ces figures sont les matrices 90 illustrées par la figure 5, mais les autres matrices décrites peuvent être utilisées. Ces matrices sont associées au circuit de lecture 30.

Des éléments optiques tels que des couches antireflet, des filtres colorés uniformément ou zonés selon les pixels, des systèmes de concentration de lumière, peuvent être déposés ou formés sur toute la surface ou encore rapportés et collés par point. La figure 7 montre un élément optique 5 formé sur toute la surface de la matrice de photodétecteurs 90. La figure 8 montre un élément optique 6 collé par points sur la matrice de photodétecteurs 90.

Plusieurs matrices de photodétecteurs peuvent être réalisées simultanément et reportées simultanément sur des circuits de lecture CMOS.

On va maintenant décrire la réalisation des structures décrites précédemment. Les pixels décrits sont de forme rectangulaire mais des pixels triangulaires, ou hexagonaux ou même de taille variable sont envisageables selon la contrainte de l'ensemble du système de mesure ou d'imagerie.

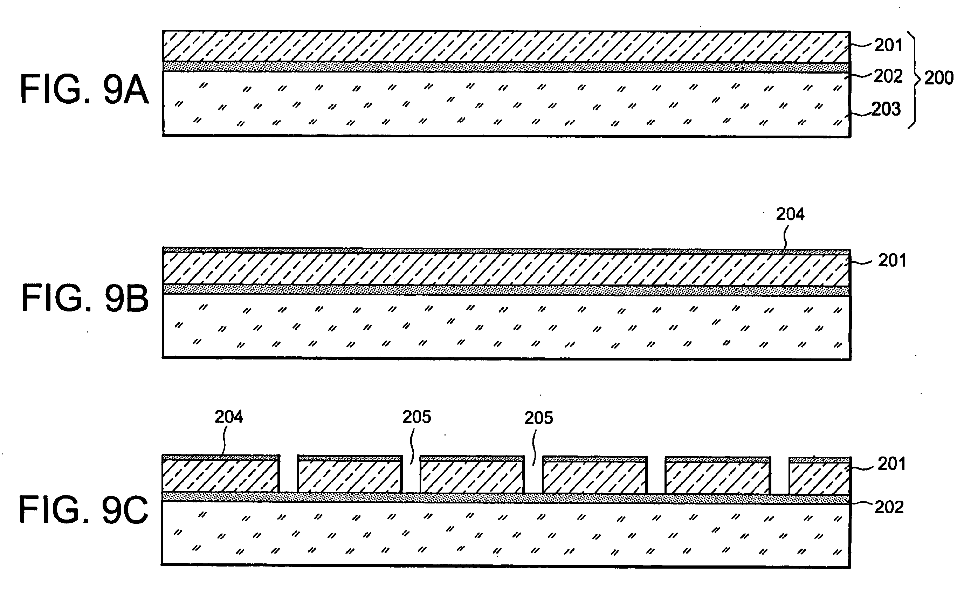

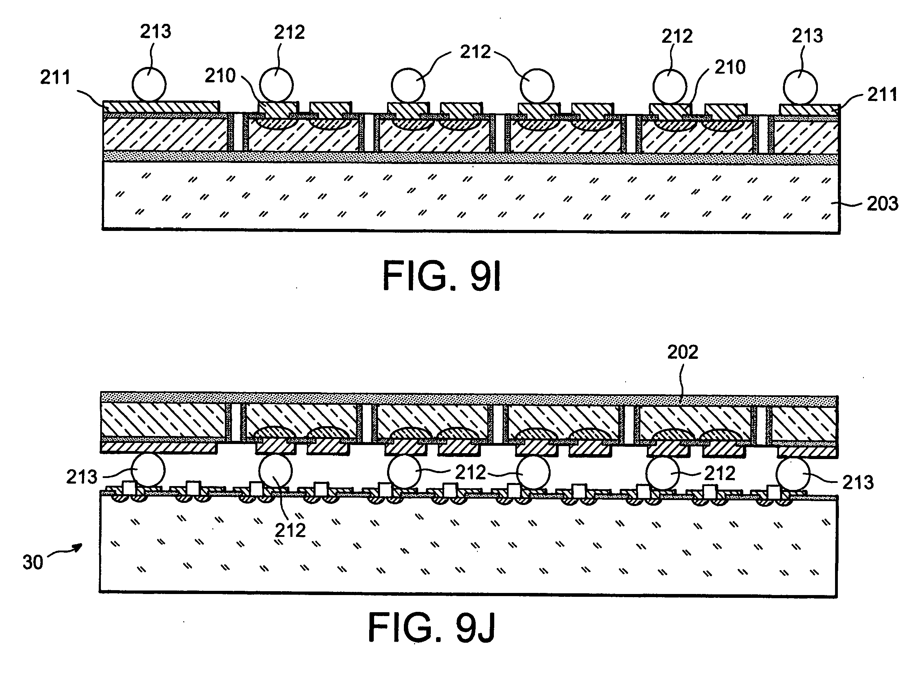

Les figures 9A à 9J illustrent la réalisation d'une matrice de photodétecteurs hybridée sur un circuit de lecture selon le premier mode de réalisation de l'invention. Les figures 9A à 9H illustrent la réalisation de la matrice de photodétecteurs uniquement. Les figures 9I et 9J illustrent l'hybridation de la matrice de photodétecteurs à son circuit de lecture. Toutes ces figures sont des vues en coupe transversale.

La figure 9A montre un substrat SOI (de l'anglais "Silicon On Insulator") 200 constitué d'un support en silicium 203 supportant successivement une couche d'oxyde de silicium 202 et une couche mince de silicium 201.

La couche mince de silicium 201 subit une étape d'oxydation pour obtenir une couche de passivation de surface et de protection 204 (voir la figure 9B). La couche 204 a une épaisseur de l'ordre de 0,5 µm.

Des tranchées sont ensuite réalisées dans la couche mince 201. Pour cela, une couche de résine est d'abord déposée sur la couche d'oxyde 204, puis est photolithographiée pour réaliser une gravure de la couche d'oxyde 204 aux emplacements prévus pour les tranchées. Après la gravure de la couche d'oxyde 104, la résine est retirée. Les tranchées 205 sont ensuite gravées dans la couche mince de silicium 201 jusqu'à atteindre la couche d'oxyde 202. C'est ce que montre la figure 9C.

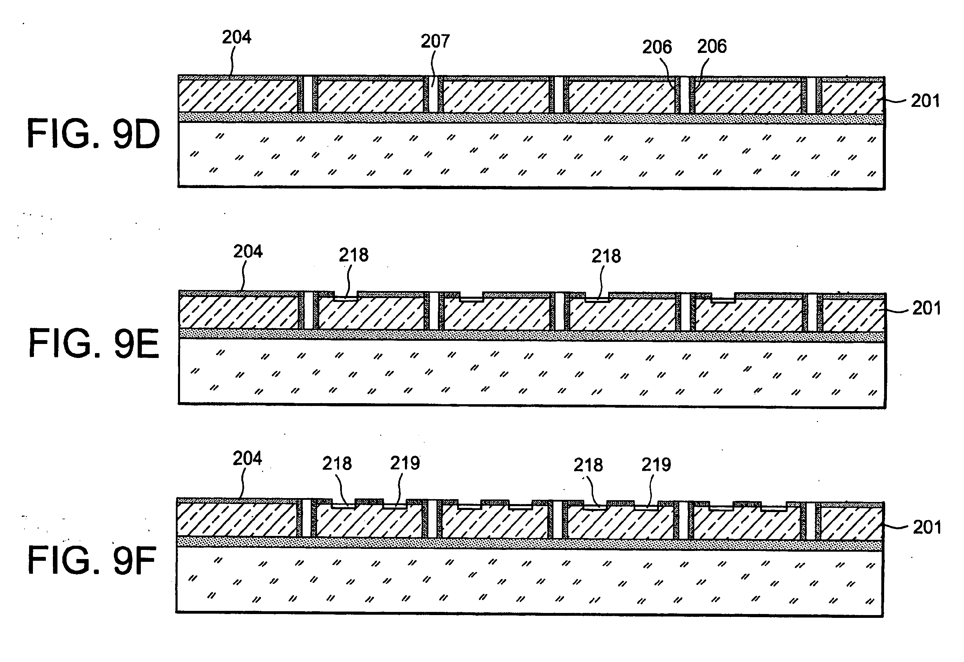

On procède ensuite à une oxydation de surface des parties de silicium apparentes pour obtenir une couche continue d'oxydation de surface 204-206 de la couche mince de silicium 201. Les tranchées sont alors remplies de polysilicium 207, un polissage mécano-chimique étant effectué pour éliminer le polysilicium en surface. C'est ce que montre la figure 9D.

Les pixels étant ainsi délimités, des zones dopées peuvent être réalisées dans le matériau semiconducteur.

La figure 9E montre le résultat obtenu, en vue de créer de premières zones dopées, après des opérations de dépôt d'une couche de résine, photolithographie de la résine, gravure de la couche d'oxyde 204, implantation de dopants dans les zones 218 de matériau photoconducteur exposé et retrait de la résine.

La figure 9F montre le résultat obtenu, en vue de créer de secondes zones dopées, après des opérations de dépôt d'une nouvelle couche de résine, photolithographie de la résine, nouvelle gravure de la couche d'oxyde 204, implantation de dopants complémentaires dans les zones 219 de matériau semiconducteur exposé et retrait de la résine.

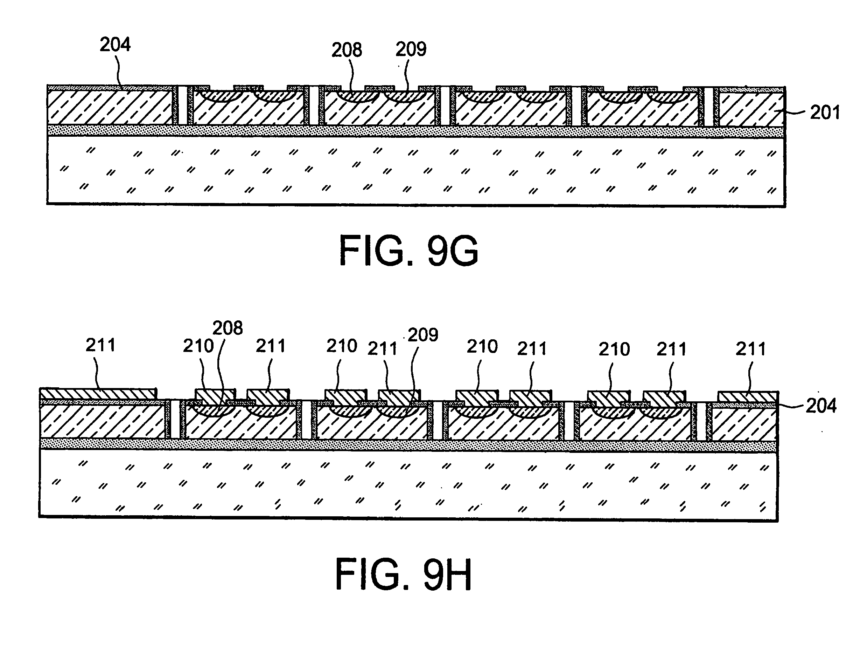

La figure 9G montre le résultat obtenu après une désoxydation partielle des zones dopées précédemment et après un recuit de diffusion et d'activation des dopants. On obtient des pixels possédant les zones dopées complémentaires 208 et 209.

La figure 9H montre le résultat obtenu après le dépôt d'une couche de métal suivi du dépôt d'une couche de résine, la photolithographie de la résine, la gravure de la couche de métal et le retrait de la résine. On obtient des plots de connexion individuels 210 connectant les zones dopées 208 et une électrode commune 211 connectant toutes les zones dopées 209 et comprenant des plages en bordure de plaque.

La figure 9I montre le résultat obtenu après la formation de billes conductrices 212 sur les plots de connexion 210 et de billes conductrices 213 sur les plages de bordure de l'électrode 211. Une autre façon de faire est de former les billes fusibles sur le circuit de lecture.

La figure 9J montre la structure finalement obtenue après les opérations suivantes :
- hybridation du dispositif de la figure 9I par une technique de type "flip-chip" sur le circuit de lecture 30 déjà décrit,
- éventuellement, remplissage entre les billes 212 et 213 si nécessaire (non représenté sur la figure),
- élimination du support en silicium 203 (voir la figure 9I) par polissage et/ou gravure avec arrêt sur la couche de silice enterrée 202.

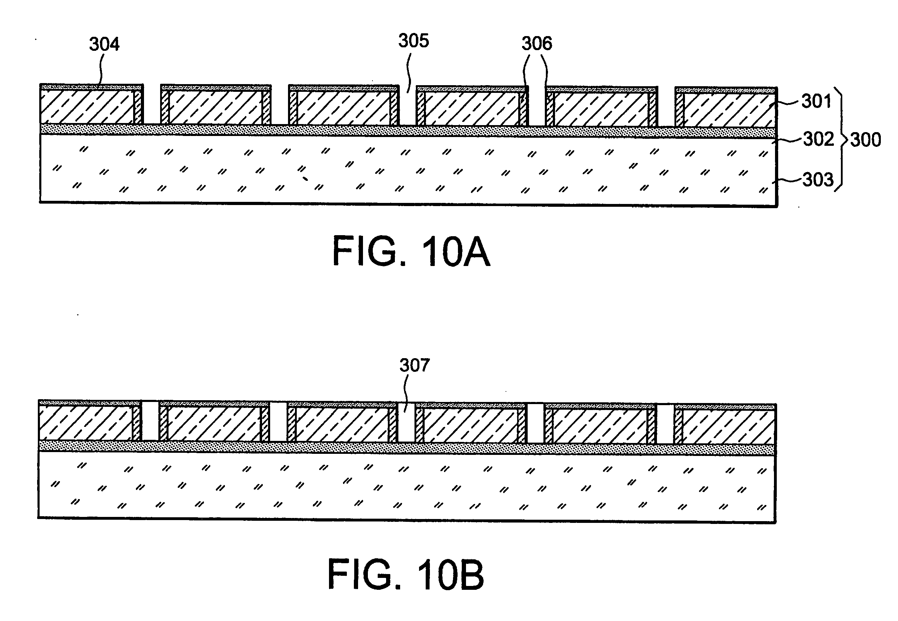

Les figures 10A à 10D illustrent la réalisation d'une matrice de photodétecteurs hybridée sur un circuit de lecture selon le deuxième mode de réalisation de l'invention. Toutes ces figures sont des vues en coupe.

Pour ce deuxième mode de réalisation, les premières étapes sont identiques à celles illustrées par les figures 9A à 9C.

La figure 10A montre le résultat obtenu après dopage du silicium exposé suivi d'un recuit de diffusion. La référence 300 désigne le substrat SOI de départ constitué d'un support en silicium 303 supportant successivement une couche d'oxyde de silicium 302 et une couche mince de silicium 301. La référence 304 désigne la couche de passivation de surface et de protection. La référence 305 désigne les tranchées. La référence 306 désigne les zones dopées réalisées selon un premier type de dopage, par exemple par diffusion depuis un gaz.

Les tranchées 305 sont alors remplies de polysilicium dopé. Le surplus de remplissage est éliminé par polissage mécano-chimique. On obtient la structure représentée à la figure 10B où la référence 307 désignez les parois conductrices en polysilicium des murs.

Dans un cas particulier, il est possible pour simplifier de ne pas faire l'étape de dopage des flancs de tranchées (les zones dopées 306) et de laisser le polysilicium dopé des parois conductrices transmettre plus tard, dans l'étape de diffusion qui va suivre, ses dopants aux parois.

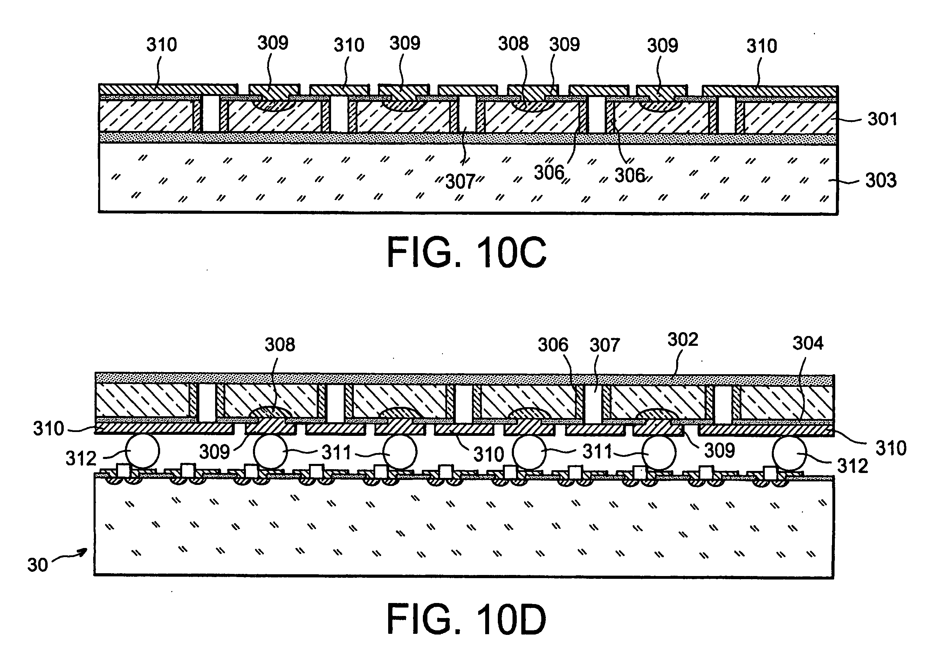

Le procédé se poursuit ensuite par des étapes semblables à celles décrites pour le procédé du premier mode de réalisation : dépôt d'une couche de résine, photolithographie de la résine déposée, gravure de la couche d'oxyde 304, implantation d'un dopant complémentaire dans la couche mince 301, retrait de la résine, recuit de diffusion et d'activation des dopants, dépôt d'une couche de métal suivi du dépôt d'une couche de résine, photolithographie de la résine déposée, gravure de la couche de métal et retrait de la résine. Le résultat obtenu est illustré par la figure 10C où l'on reconnaît les zones 308 dopées avec le dopant complémentaire, les plots de connexion particuliers 309 en contact avec les zones dopées 308 et l'électrode 310 commune à toutes les parois conductrices 307.

Viennent ensuite les étapes suivantes comprenant la formation de billes fusibles, l'hybridation de type "flip-chip" sur le circuit de lecture, éventuellement le remplissage entre les billes, l'élimination du support du substrat SOI par polissage et/ou gravure avec arrêt sur la couche de silice enterrée. On obtient la structure représentée à la figure 10D où la référence 30 désigne le circuit de lecture déjà décrit, la référence 311 désigne les billes connectant les plots 309 au circuit de lecture et où la référence 312 désigne les billes connectant l'électrode commune 310 au circuit de lecture.

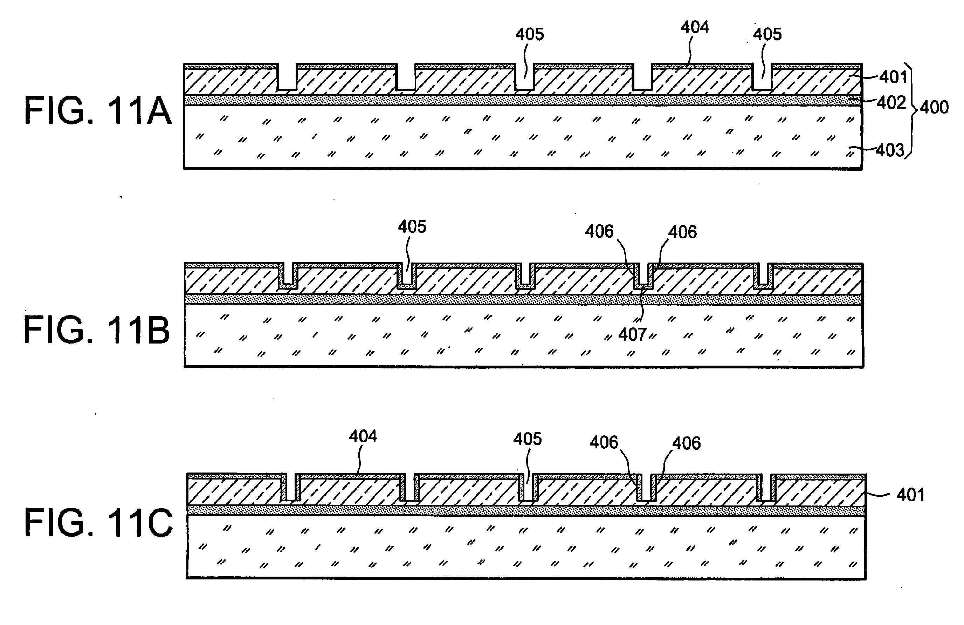

Les figures 11A à 11H illustrent la réalisation d'une matrice de photodétecteurs hybridée sur un circuit de lecture selon le troisième mode de réalisation de l'invention. Toutes ces figures sont des vues en coupe transversales.

On part d'un substrat SOI 400 constitué d'un support en silicium 403 supportant successivement une couche d'oxyde enterrée 402 et une couche mince de silicium 401. Comme pour l'étape illustrée par la figure 9B, une couche 404 de passivation de surface et de protection est obtenue par oxydation.

Pour obtenir la structure représentée à la figure 11A, une couche de résine est déposée sur la couche d'oxyde 404 et photolithographiée. La couche d'oxyde 404 est gravée en des emplacements déterminés et la couche de résine est retirée. Des tranchées 405 sont alors gravées dans la couche mince 401 sans atteindre la couche enterrée 402.

On procède ensuite à une légère oxydation des surfaces de silicium exposées, c'est-à-dire dans les tranchées. C'est ce que montre la figure 11B, où les flancs des tranchées 405 sont recouverts de couches d'oxyde 406 et où le fond de ces tranchées est recouvert d'une couche d'oxyde 407.

On procède ensuite à une gravure anisotrope de la couche d'oxyde recouvrant la couche mince de silicium 401. Cette gravure est destinée à éliminer la couche d'oxyde située au fond des tranchées. La couche d'oxyde 404 est peu affectée par cette gravure car son épaisseur est largement supérieure à la couche d'oxyde située au fond des tranchées. On obtient la structure représentée à la figure 11C où les tranchées 405 sont recouvertes d'une couche d'oxyde 406 uniquement sur leurs flancs.

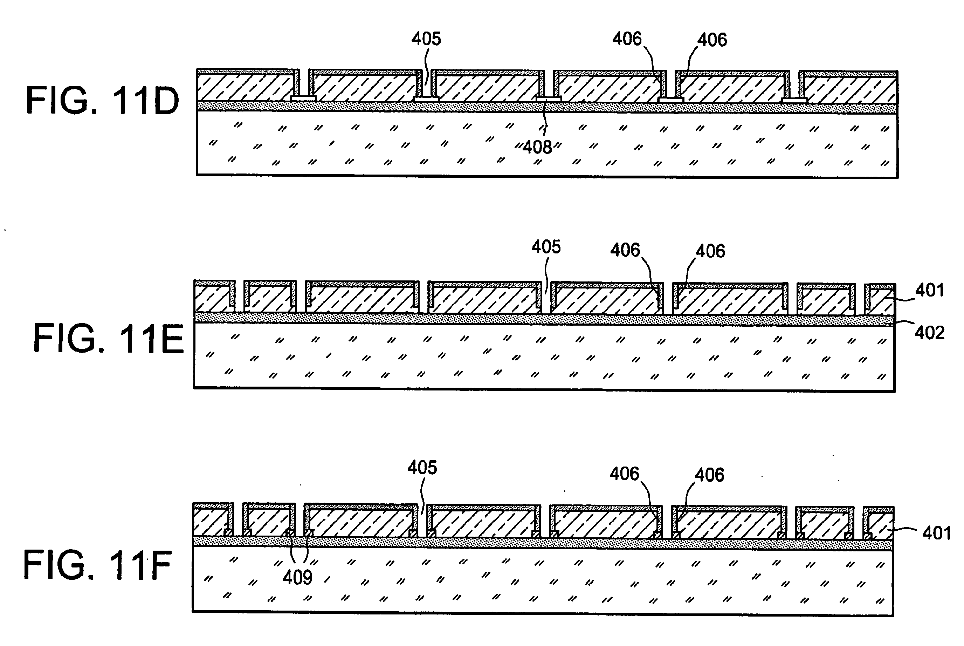

Ensuite, des dopants sont implantés ou diffusés depuis un gaz chaud au fond des tranchées 405 et un recuit de diffusion est effectué. Les dopants diffusent dans le silicium et pas dans l'oxyde pour fournir des zones dopées 408 comme le montre la figure 11D. Ces zones dopées 408 serviront de point commun à toutes les photodiodes.

Une variante consiste à ajouter une étape de gravure supplémentaire de la couche mince de silicium 401 à la structure montrée par la figure 11C. Cette gravure supplémentaire et anisotrope est effectuée jusqu'à atteindre la couche d'oxyde enterrée 402 comme le montre la figure 11E. Les flancs des tranchées 405 sont donc en oxyde de silicium pour la partie haute et en silicium pour la partie basse.

Des dopants sont alors diffusés depuis un gaz chaud dans le silicium exposé des tranchées 405, ce qui permet d'obtenir des zones dopées 409 dans la couche mince de silicium 401 comme le montre la figure 11F.

Pour obtenir un dispositif correspondant à la figure 3 à partir de la structure de la figure 11D, ou un dispositif correspondant à la figure 4 à partir de la structure de la figure 11F, des étapes déjà décrites pour les modes de réalisation précédents sont mises en oeuvre.

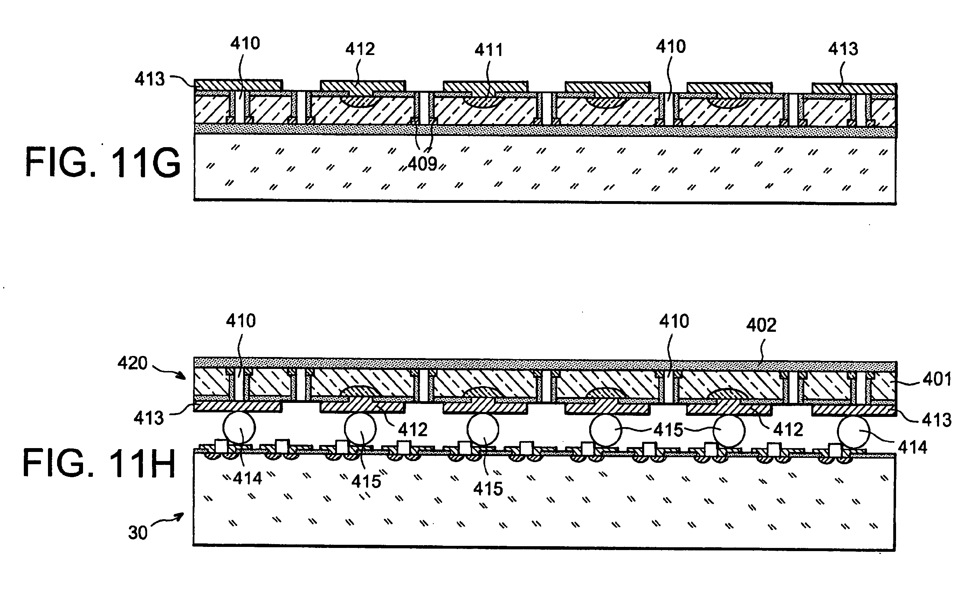

Pour obtenir des pixels plus petits, il est avantageux de ne pas placer de métal sur les parois conductrices remplissant les tranchées délimitant les pixels. La place occupée par la grille de métal au-dessus de la grille de tranchées est donc gagnée. Par contre, des tranchées sont ajoutées en bordure de plaque pour permettre la liaison électrique avec le circuit de lecture. C'est ce que montre la figure 11G qui représente la structure obtenue à partir de la structure montrée à la figure 11F.

Sur la figure 11G, la référence 410 désigne les parois conductrices des murs, la référence 411 désigne des zones dopées d'un type de dopage complémentaire au dopage des zones 409, la référence 412 désigne les plots de connexion contactant les zones dopées 411, la référence 413 désigne des plages conductrices reliées électriquement aux parois conductrices 410.

Après la mise en oeuvre d'étapes déjà décrites pour les modes de réalisation précédents, on obtient la structure représentée à la figure 11H, où la matrice de photodétecteurs 420 est hybridée sur le circuit de lecture 30 déjà décrit. Les plages conductrices 413 sont reliées électriquement au circuit de lecture 30 par les billes conductrices 414 et les plots de connexion 412 sont reliés au circuit de lecture 30 par les billes conductrices 415.

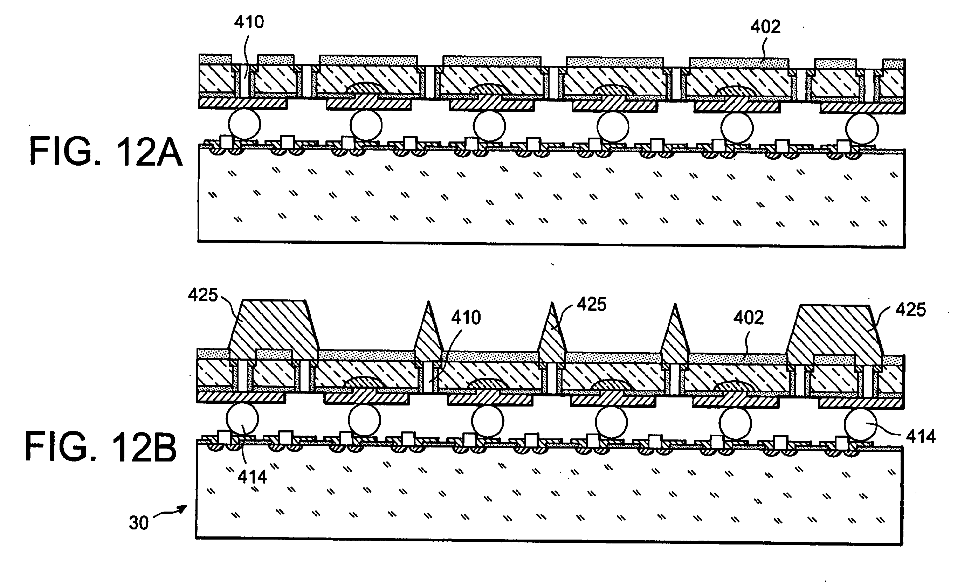

Les figures 12A et 12B illustrent la réalisation d'une matrice de photodétecteurs hybridée sur un circuit de lecture selon le quatrième mode de réalisation de l'invention. Ces figures sont des vues en coupe transversales.

La structure à obtenir peut être réalisée en complétant la structure représentée à la figure 11H. Une couche de résine est déposée sur la couche d'oxyde 402 et photolithographiée pour exposer des emplacements de cette couche situés au-dessus des parois conductrices 410. La couche d'oxyde 402 est gravée et la résine est retirée. On obtient la structure illustrée par la figure 12A.

Ensuite, une couche métallique est déposée sur la couche d'oxyde 402. Une couche de résine est déposée sur la couche métallique et est photolithographiée. La couche métallique est gravée avec maîtrise de la pente des gravures. La résine est retirée. On obtient la structure illustrée par la figure 12B où une électrode commune 425 assure la connexion électrique des parois conductrices 410 au circuit de lecture 30 par l'intermédiaire des billes fusibles 414.

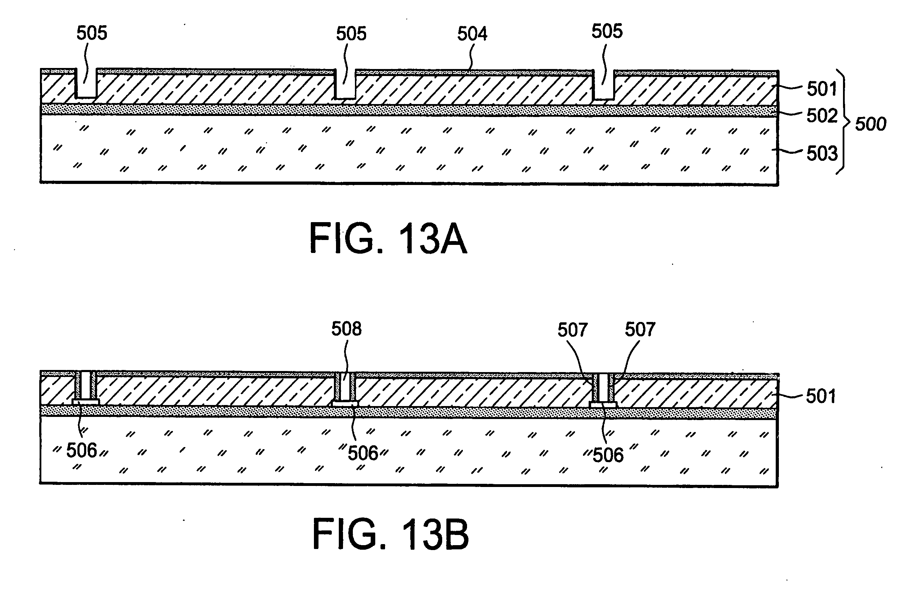

Les figures 13A à 13F illustrent la réalisation d'une matrice de photodétecteurs hybridée sur un circuit de lecture selon le cinquième mode de réalisation de l'invention. Ces figures sont des vues en coupe transversale.

Le procédé de réalisation illustré par ces figures ne diffère des procédés décrits précédemment que par l'enchaînement et la multiplication des étapes mais pas sur le principe.

Les premières étapes sont identiques à celles illustrées par les figures 9A et 9B. On part d'un substrat SOI 500 constitué d'un support en silicium 503 supportant successivement une couche d'oxyde enterrée 502 et une couche mince de silicium 501. Comme pour l'étape illustrée par la figure 9B, une couche 504 de passivation de surface et de protection est obtenue par oxydation.

Pour obtenir la structure représentée à la figure 13A, une couche de résine est déposée sur la couche d'oxyde 504 et photolithographiée. La couche d'oxyde 504 est gravée en des emplacements déterminés et la couche de résine est retirée. Des tranchées 505 sont alors gravées dans la couche mince 501 sans atteindre la couche d'oxyde enterrée 502.

On procède ensuite à une légère oxydation des surfaces de silicium exposées, c'est-à-dire dans les tranchées. Une désoxydation anisotrope est effectuée pour simplement éliminer la couche d'oxyde du fond des tranchées et exposer le silicium de la couche mince 501. Des dopants sont alors implantés ou diffusés depuis un gaz dans le silicium exposé et leur diffusion est effectuée. Les tranchées sont alors remplies de polysilicium dopé et le surplus de remplissage est éliminé par polissage. On obtient la structure illustrée par la figure 13B où la référence 506 désigne les zones dopées, la référence 507 désigne les couches d'oxyde recouvrant les flancs des tranchées et la référence 508 désigne les parois conductrices correspondant aux zones dopées 506.

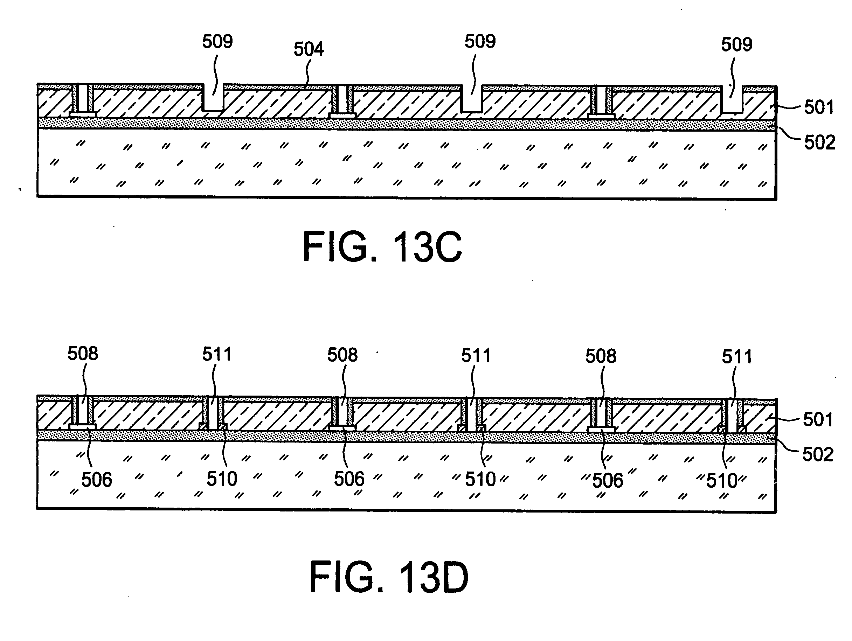

La structure est alors recouverte d'une couche de résine qui est photolithographiée. La couche d'oxyde 504 est gravée en des emplacements déterminés entre les tranchées réalisées précédemment et la couche de résine est retirée. Des tranchées 509 sont alors gravées dans la couche mince 501 sans atteindre la couche d'oxyde enterrée 5.02. C'est ce que montre la figure 13C.

On procède ensuite à une légère oxydation des surfaces de silicium exposées, c'est-à-dire dans les tranchées 509. Une désoxydation anisotrope est effectuée pour simplement éliminer la couche d'oxyde du fond des tranchées et exposer le silicium de la couche mince 501. On procède alors à une gravure du silicium exposé jusqu'à atteindre la couche d'oxyde enterrée 502. Des dopants sont alors implantés ou diffusés depuis un gaz, ces dopants étant complémentaires des dopants des zones dopées 506, et un recuit de diffusion est effectué. Les tranchées 509 sont alors remplies de polysilicium dopé et le surplus de remplissage est éliminé par polissage. On obtient la structure illustrée par la figure 13D où la référence 510 désigne les nouvelles zones dopées et la référence 511 désigne les parois conductrices correspondantes.

Ensuite se déroulent des étapes non représentables sur ces vues en coupe et qui sont destinées à la formation de tranchées isolantes électriquement dans la direction perpendiculaire aux tranchées 505 et 509. Ces étapes sont des étapes d'oxydation de surface, de dépôt de couche de résine, de photolithographie de la résine déposée, de gravure de la couche d'oxyde exposée, de retrait de la résine, de gravure du silicium exposé jusqu'à la couche d'oxyde enterrée, d'oxydation, de remplissage des tranchées, de polissage de la surface pour éliminer le surplus de remplissage, de dépôt d'une nouvelle couche de résine suivi de sa photolithographie pour graver l'oxyde formé sur les parois conductrices en polysilicium, enfin de retrait de la résine.

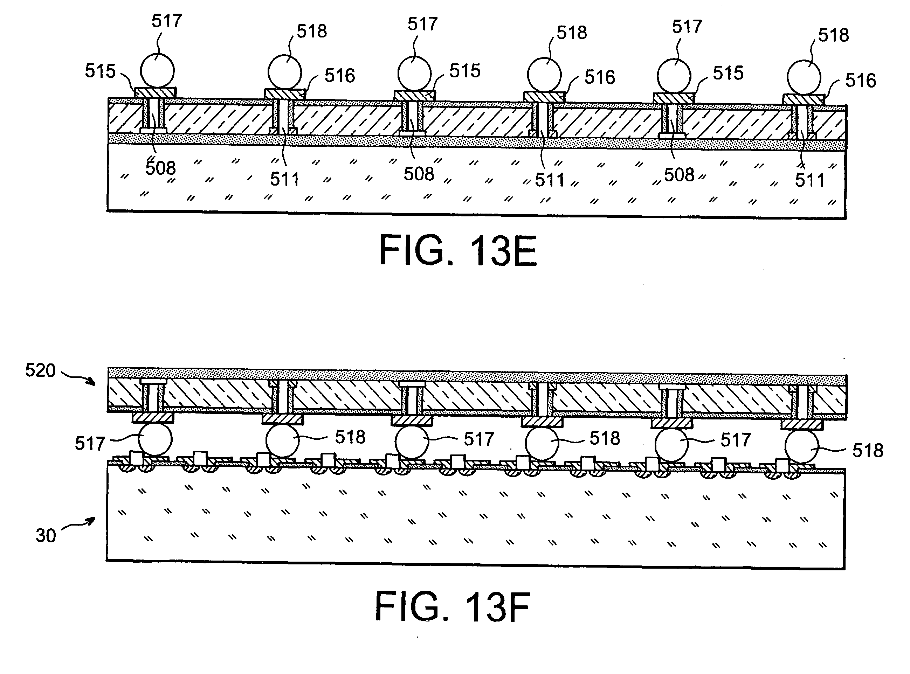

Une couche métallique est ensuite déposée sur la structure, puis une couche de résine. La couche de résine est photolithographiée et le métal est gravé pour ne garder que des plots de connexion sur les parois conductrices. La résine est retirée. Des billes fusibles sont alors formées sur les plots de connexion. On obtient la structure représentée à la figure 13E où la référence 515 désigne un plot de connexion correspondant à un mur conducteur 508 et où la référence 516 désigne un plot de connexion correspondant à un mur conducteur 511. La référence 517 désigne une bille conductrice correspondant à un plot de connexion 515 et la référence 518 désigne une bille conductrice correspondant à un plot de connexion 516.

Après la mise en oeuvre d'étapes déjà décrites pour les modes de réalisation précédents, on obtient la structure représentée à la figure 13F où la matrice de photodétecteurs 520 est hybridée sur le circuit de lecture 30 déjà décrit.

Les techniques pour réaliser les assemblages illustrés par les figures 7 et 8 sont très variées. Elles doivent être compatibles avec les procédés de réalisation mis en oeuvre précédemment. Les problèmes qui pourraient survenir sont relatifs aux échauffements à haute température et aux contraintes dues au refroidissement de matériaux de nature différente. Comme il s'agit en général de dépôts de couches minces par évaporation pour former une couche antireflet ou une couche filtre, les échauffements sont faibles. Les structures selon l'invention étant formées de matériaux durs, la compatibilité ne pose pas de problème. De même, tout étalement ou gravure de polymère ou de plastique est compatible avec ces structures dès lors qu'on a pris soin de combler l'espace séparant les plaques hybridées. Le collage de pièces ne pose pas non plus de problème.

Des variantes de ces structures sont possibles simplement en remplaçant les zones 16, 17 (voir la figure 1), 56 (voir la figure 2), 76 (voir la figure 3) et 96 (voir la figure 4) qui sont à dopage unique par des zones à double ou triple dopage de profondeur différente et de type identique ou complémentaire.

Les dimensions des structures selon l'invention sont variables selon les applications. L'épaisseur de la plaque photosensible est de quelques µm à quelques dizaines de µm. La largeur des pixels est voisine de l'épaisseur de la plaque photosensible. La largeur des murs est voisine du dixième de l'épaisseur de la plaque ou même moins car on cherche à la minimiser. Les zones dopées sont inférieures ou égales à la taille du pixel et peuvent être très fines (inférieures à 0,1 µm). Les matrices peuvent contenir de quelques dizaines à quelques millions de pixels.

## Revendications

1. Matrice de photodétecteurs destinée à être hybridée sur un circuit de lecture et constituée à partir d'une plaque de matériau semiconducteur présentant une face de réception d'une lumière à détecter et une face opposée dite face d'hybridation, la plaque étant divisée en pixels, chaque pixel constituant un photodétecteur (12, 52, 72, 92), la face d'hybridation présentant des plots de connexion (18, 58, 78, 98) permettant d'hybrider la matrice de photodétecteurs au circuit de lecture, **caractérisée en ce que** les pixels sont séparés les uns des autres par des murs formés transversalement dans toute l'épaisseur de la plaque.

2. Matrice de photodétecteurs selon la revendication 1, **caractérisée en ce que** chaque photodétecteur (12) comprend une zone dopée selon un premier type de dopage et en contact électrique avec un plot de connexion correspondant (18) de la face d'hybridation, chaque photodétecteur comprenant également une zone dopée selon un deuxième type de dopage (17) complémentaire du premier type de dopage et en contact électrique avec une électrode (19) commune à tous les photodétecteurs et supportée par la face d'hybridation, les murs présentant une paroi électriquement isolante aux photodétecteurs.

3. Matrice de photodétecteurs selon la revendication 1, **caractérisée en ce que** chaque photodétecteur (12) comprend une zone dopée selon un premier type de dopage et en contact électrique avec un plot de connexion correspondant (18) de la face d'hybridation, chaque photodétecteur comprenant également une zone dopée selon un deuxième type de dopage (17) complémentaire du premier type de dopage et en contact électrique avec un plot de connexion correspondant de la face d'hybridation, les murs présentant une paroi électriquement isolante aux photodétecteurs.

4. Matrice de photodétecteurs selon la revendication 1, **caractérisée en ce que** chaque photodétecteur (52, 72, 92) comprend une zone dopée selon un premier type de dopage (56, 76, 96) et en contact électrique avec un plot de connexion correspondant (58, 78, 98) de la face d'hybridation, chaque photodétecteur comprenant également une zone dopée selon un deuxième type de dopage (57, 77, 97) complémentaire du premier type de dopage et en contact électrique avec des moyens conducteurs électriques (53, 73, 93) des murs, les moyens conducteurs électriques des murs étant connectés à une électrode commune.

5. Matrice de photodétecteurs selon la revendication 4, **caractérisée en ce que** ladite électrode commune est supportée par la face d'hybridation de la matrice de photodétecteurs.

6. Matrice de photodétecteurs selon la revendication 4, **caractérisée en ce que** la zone dopée selon le deuxième type de dopage (57) s'étend sur toute l'épaisseur de la plaque de matériau semiconducteur (51).

7. Matrice de photodétecteurs selon la revendication 6, **caractérisée en ce que** chaque photodétecteur comprend en outre une couche de la plaque de matériau semiconducteur, adjacente à la face de réception d'une lumière, dopée selon le deuxième type de dopage.

8. Matrice de photodétecteurs selon la revendication 4, **caractérisée en ce que**, les murs présentant un sommet n'atteignant pas la face de réception d'une lumière, la zone dopée selon le deuxième type de dopage (77) est située entre ledit sommet et la face de réception d'une lumière.

9. Matrice de photodétecteurs selon la revendication 4, **caractérisée en ce que** la zone dopée selon le deuxième type de dopage (97) est localisée près de la face de réception d'une lumière.

10. Matrice de photodétecteurs selon la revendication 4, **caractérisée en ce que** ladite électrode commune (104) est supportée par la face de réception d'une lumière, des moyens de liaison électrique (93) traversant la plaque de matériau semiconducteur (91) pour relier ladite électrode commune à une plage conductrice (105) située sur la face d'hybridation.

11. Matrice de photodétecteurs selon la revendication 10, **caractérisée en ce que** ladite électrode commune (104) comprend des conducteurs électriques possédant une forme permettant de réfléchir la lumière à détecter vers les parties de la face de réception dépourvues de conducteurs électriques.

12. Matrice de photodétecteurs selon la revendication 11, **caractérisée en ce que** ladite forme des conducteurs électriques est une pointe dirigée vers la lumière à détecter.

13. Matrice de photodétecteurs selon la revendication 1, **caractérisée en ce que** chaque photodétecteur (112) comprend une zone dopée selon un premier type de dopage (117) et une zone dopée selon un deuxième type de dopage (116) complémentaire du premier type de dopage, ces zones dopées étant localisées près de la face de réception d'une lumière et étant reliées à des plots de connexion (118, 119) correspondant de la face d'hybridation par des moyens conducteurs électriques (113, 123) prévus dans les murs.

14. Matrice de photodétecteurs selon la revendication 13, **caractérisée en ce que** les zones dopées selon le premier type de dopage (117) correspondent à des murs présentant un sommet n'atteignant pas la face de réception d'une lumière, les zones dopées selon le premier type de dopage (117) étant alors localisées entre les sommets des murs et la face de réception d'une lumière, les zones dopées selon le deuxième type de dopage (116) correspondant à des murs présentant un sommet atteignant la face de réception d'une lumière.

15. Matrice de photodétecteurs selon la revendication 13, **caractérisée en ce que** les zones dopées correspondent à des murs présentant un sommet n'atteignant pas la face de réception d'une lumière, les zones dopées étant alors localisées entre les sommets des murs et la face de réception d'une lumière.

16. Matrice de photodétecteurs selon la revendication 13, **caractérisée en ce que** les zones dopées correspondent à des murs présentant un sommet atteignant la face de réception d'une lumière.

17. Matrice de photodétecteurs selon l'une quelconque des revendications 1 à 16, **caractérisée en ce que** la face de réception d'une lumière supporte au moins un élément optique (5, 6).

18. Matrice de photodétecteurs selon la revendication 17, **caractérisée en ce que** ledit élément optique est un élément choisi parmi une couche antireflet, un filtre coloré et un système de concentration de lumière.

## Claims

1. Array of photodetectors intended to be hybridised on a readout circuit and consisting of a wafer in semiconductor material having one surface receiving light to be detected and an opposite so-called hybridisation surface, the wafer being divided into pixels, each pixel forming a photodetector (12, 52, 72, 92), the hybridisation surface having connection pads (18, 58, 78, 98) with which to hybridise the array of photodetectors to the readout circuit, **characterized in that** the pixels are separated from one another by walls formed crosswise over the entire thickness of the wafer.

2. Array of photodetectors as in claim 1, **characterized in that** each photodetector (12) comprises a zone doped according to a first doping type and in electric contact with a corresponding connection pad (18) on the hybridisation surface, each photodetector also comprising a zone doped according to a second doping type (17) complementary to the first doping type and in electric contact with an electrode (19) common to all the photodetectors and carried by the hybridisation surface, the walls having a surface electrically insulated from the photodetectors.

3. Array of photodetectors as in claim 1, **characterized in that** each photodetector (12) comprises a zone doped according to a first doping type and in electric contact with a corresponding connection pad (18) on the hybridisation surface, each photodetector also comprising a zone doped according to a second doping type (17) complementary to the first doping type and in electric contact with a corresponding connection pad on the hybridisation surface, the walls having a surface electrically insulated from the photodetectors.

4. Array of photodetectors as in claim 1, **characterized in that** each photodetector (52, 72, 92) comprises a zone doped according to a first doping type (56, 76, 96) and in electric contact with a corresponding connection pad (58, 78, 98) on the hybridisation surface, each photodetector also comprising a zone doped according to a second doping type (57, 77, 97) complementary to the first doping type and in electric contact with electric conductor means (53, 73, 93) of the walls, the wall electric conductor means being connected to a common electrode.

5. Array of photodetectors as in claim 4, **characterized in that** said common electrode is carried by the hybridisation surface of the array of photodetectors.

6. Array of photodetectors as in claim 4, **characterized in that** the zone doped according to the second doping type (57) extends over the entire thickness of the wafer in semiconductor material (51).

7. Array of photodetectors as in claim 6, **characterized in that** each photodetector also comprises a layer of the wafer in semiconductor material, adjacent to the light receiving surface, doped according to the second doping type.

8. Array of photodetectors as in claim 4, **characterized in that**, for the walls whose summit does not reach the light receiving surface, the zone doped according to the second doping type (77) is located between said summit and the light receiving surface.

9. Array of photodetectors as in claim 4, **characterized in that** the zone doped according to the second doping type (97) is located close to the light receiving surface.

10. Array of photodetectors as in claim 4, **characterized in that** said common electrode (104) is carried by the light receiving surface, electric connection means (93) passing through the wafer in semiconductor material (91) to connect said common electrode to a conductor band (105) located on the hybridisation surface.

11. Array of photodetectors as in claim 10, **characterized in that** said common electrode (104) comprises electric conductors having a shape enabling reflectance of the light to be detected towards the portions of the receiving surface devoid of electric conductors.

12. Array of photodetectors as in claim 11, **characterized in that** said shape of the electric conductors is a point directed towards the light to be detected.

13. Array of photodetectors as in claim 1, **characterized in that** each photodetector (112) comprises a zone doped according to a first doping type (117) and a zone doped according to a second doping type (116) complementary to the first doping type, these doped zones being located close to the light receiving surface and being connected to corresponding connection pads (118, 119) on the hybridisation surface via electric conductor means (113, 123) provided in the walls.

14. Array of photodetectors as in claim 13, **characterized in that** the zones doped according to the first doping type (117) correspond to walls having summit which does not reach the light receiving surface, the zones doped according to the first doping type (117) then being located between the summits of the walls and the light receiving surface, the zones doped according to the second doping type (116) corresponding to walls having a summit which reaches the light receiving surface.

15. Array of photodetectors as in claim 13, **characterized in that** the doped zones correspond to walls having a summit which does not reach the light receiving surface, the doped zones then being located between the wall summits and the light receiving surface.

16. Array of photodetectors as in claim 13, **characterized in that** the doped zones correspond to walls having a summit which reaches the light receiving surface.

17. Array of photodetectors as in any of claims 1. to 16, **characterized in that** the light receiving surface carries at least one optic member (5, 6).

18. Array of photodetectors as in claim 17, **characterized in that** said optic member is chosen from among an antireflection layer, a coloured filter and a light concentration system.

## Patentansprüche

1. Photodetektormatrix, bestimmt zur Hybridisierung auf eine Leseschaltung und gebildet durch eine Platte aus Halbleitermaterial mit einer Empfangsseite eines zu detektierenden Lichts und einer Hybridisierungsseite genannten entgegengesetzten Seite, wobei die Platte in Pixel unterteilt ist, jedes Pixel einen Photodetektor (12, 52, 72, 92) bildet und die Hybridisierungsseite Verbindungselemente (18, 58, 78, 98) umfasst, die ermöglichen, die Photodetektormatrix auf die Leseschaltung zu hybridisieren,
**dadurch gekennzeichnet, dass** die Pixel durch Mauern voneinander getrennt sind, welche die gesamte Dicke der Platte durchqueren.

2. Photodetektormatrix nach Anspruch 1, **dadurch gekennzeichnet, dass** jeder Photodetektor (12) eine gemäß einem ersten Dotierungstyp dotierte Zone umfasst, die elektrischen Kontakt hat mit einem entsprechenden Verbindungselement (18) der Hybridisierungsseite, und jeder Photodetektor auch eine gemäß einem zum ersten Dotierungstyp komplementären zweiten Dotierungstyp dotierte Zone (17) umfasst, die elektrischen Kontakt hat mit einer allen Photodetektoren gemeinsamen Elektrode (19) auf der Hybridisierungsseite, wobei die Mauern eine von den Photodetektoren elektrisch isolierende Wand aufweisen.

3. Photodetektormatrix nach Anspruch 1, **dadurch gekennzeichnet, dass** jeder Photodetektor (12) eine gemäß einem erste Dotierungstyp dotierte Zone umfasst, die elektrischem Kontakt hat mit einem entsprechenden Verbindungselement (18) der Hybridisierungsseite, und jeder Photodetektor auch eine gemäß einem zum ersten Dotierungstyp komplementären zweiten Dotierungstyp dotierte Zone (17) umfasst, die elektrischen Kontakt hat mit einem entsprechenden Verbindungselement der Hybridisierungsseite, wobei die Mauern eine von den Photodetektoren elektrisch isolierende Wand aufweisen.

4. Photodetektormatrix nach Anspruch 1, **dadurch gekennzeichnet, dass** jeder Photodetektor (52, 72, 92) eine gemäß einem ersten Dotierungstyp dotierte Zone (56, 76, 96) umfasst, die elektrischen Kontakt hat mit einem entsprechenden Verbindungselement (58, 78, 98) der Hybridisierungsseite, und jeder Photodetektor auch eine gemäß einem zum ersten Dotierungstyp komplementären zweiten Dotierungstyp dotierte Zone (57, 77, 97) umfasst, die elektrischen Kontakt hat mit elektrisch leitfähigen Einrichtungen (53, 73, 93) der Mauern, wobei die elektrisch leitfähigen Einrichtungen der Mauern mit einer gemeinsamen Elektrode verbunden sind.

5. Photodetektormatrix nach Anspruch 4, **dadurch gekennzeichnet, dass** die genannte gemeinsame Elektrode durch die Hybridisierungsseite der Photodetektormatrix getragen wird.

6. Photodetektormatrix nach Anspruch 4, **dadurch gekennzeichnet, dass** die gemäß dem zweiten Dotierungstyp dotierte Zone (57) sich über die gesamte Dicke der Halbleitermaterialplatte (51) erstreckt.

7. Photodetektormatrix nach Anspruch 6, **dadurch gekennzeichnet, dass** jeder Photodetektor außerdem eine gemäß dem zweiten Dotierungstyp dotierte an die Lichtempfangsseite angrenzende bzw. der Lichtempfangsseite zugekehrte Schicht der Halbleitermaterialplatte umfasst.

8. Photodetektormatrix nach Anspruch 4, **dadurch gekennzeichnet, dass** die Mauern eine Spitze aufweisen, welche die Lichtempfangsseite nicht erreicht, wobei die gemäß dem zweiten Dotierungstyp dotierte Zone (77) sich zwischen der genannten Spitze und der Lichtempfangsseite befindet.

9. Photodetektormatrix nach Anspruch 4, **dadurch gekennzeichnet, dass** die gemäß dem zweiten Dotierungstyp dotierte Zone (97) nahe der Lichtempfangsseite lokalisiert ist.

10. Photodetektormatrix nach Anspruch 4, **dadurch gekennzeichnet, dass** die gemeinsame Elektrode (104) durch die Lichtempfangsseite getragen wird und elektrische Verbindungseinrichtungen (93) die Halbleitermaterialplatte (91) durchqueren, um die genannte gemeinsame Elektrode mit einem leitenden Bereich (105) zu verbinden, der sich auf der Hybridisierungsseite befindet.

11. Photodetektormatrix nach Anspruch 10, **dadurch gekennzeichnet, dass** die gemeinsame Elektrode (104) elektrische Leiter umfasst, deren Form ermöglicht, das zu detektierende Licht auf Teile der Empfangsfläche ohne elektrische Leiter zu reflektierten.

12. Photodetektormatrix nach Anspruch 11, **dadurch gekennzeichnet, dass** die genannte Form der elektrischen Leiter eine in Richtung des zu detektierenden Lichts ausgerichtete Spitze ist.

13. Photodetektormatrix nach Anspruch 1, **dadurch gekennzeichnet, dass** jeder Photodetektor (112) eine gemäß einem ersten Dotierungstyp dotierte Zone (117) und eine gemäß einem zum ersten Dotierungstyp komplementären zweiten Dotierungstyp dotierte Zone (116) umfasst, wobei diese dotierten Zonen nahe der Lichtempfangsseite lokalisiert und mit entsprechenden Verbindungselementen (118, 119) der Hybridisierungsseite verbunden sind durch elektrisch leitfähige Einrichtungen (113, 123), vorgesehen in den Mauern.

14. Photodetektormatrix nach Anspruch 13, **dadurch gekennzeichnet, dass** die gemäß dem ersten Dotierungstyp dotierten Zonen (117) Mauern mit einer Spitze entsprechen, welche die Lichtempfangsseite nicht erreicht, wobei die gemäß einem ersten Dotierungstyp dotierten Zonen (117) dann zwischen den Spitzen der Mauern und der Lichtempfangsseite lokalisiert sind, und die gemäß einem zweiten Dotierungstyp dotierten Zonen (116) Mauern mit einer Spitze entsprechen, welche die Lichtempfangsseite erreicht.

15. Photodetektormatrix nach Anspruch 13, **dadurch gekennzeichnet, dass** die dotierten Zonen Mauern mit einer Spitze entsprechen, welche die Lichtempfangsseite nicht erreicht, und die dotierten Zonen dann zwischen den Spitzen der Mauern und der Lichtempfangsseite lokalisiert sind.

16. Photodetektormatrix nach Anspruch 13, **dadurch gekennzeichnet, dass** die dotierten Zonen Mauern mit einer Spitze entsprechen, welche die Lichtempfangsseite erreicht.

17. Photodetektormatrix nach einem der Ansprüche 1 bis 16, **dadurch gekennzeichnet, dass** die Lichtempfangsseite wenigstens ein optisches Element (5, 6) trägt.

18. Photodetektormatrix nach Anspruch 17, **dadurch gekennzeichnet, dass** das genannte optische Element ein unter einer Antireflexschicht, einem Farbenfilter und einem Lichtkonzentrationssystem ausgewähltes Element ist.
